# EUROPEAN PATENT SPECIFICATION

(11) **EP 4 363 869 B1**
(45) Date of publication and mention of the grant of the patent: **28.10.2026**
(21) Application number: 22744011.2
(22) Date of filing: 21.06.2022
(51) Int. Cl.: G01R 19/155

(54) **ABSENCE OF VOLTAGE DETECTION DEVICE FOR MEDIUM VOLTAGE**
VORRICHTUNG ZUR ERKENNUNG DER ABWESENHEIT EINER SPANNUNG FÜR MITTELSPANNUNG
DISPOSITIF DE DÉTECTION D'ABSENCE DE TENSION POUR TENSION MOYENNE

(30) Priority: 02.07.2021 US 202163217835 P; 02.11.2021 US 202117517134
(43) Date of publication of application: 08.05.2024
(73) Proprietor: Panduit Corp., Tinley Park, Illinois 60487 (US)
(72) Inventor: BOLOURI-SARANSAR, Masud, Orland Park, Illinois 60462 (US); BALID, Walid, Orland Park, Illinois 60467 (US)
(74) Representative: Roberts, Gwilym Vaughan
(86) International application number: PCT/US2022/034304
(87) International publication number: WO 2023/278200

(56) References cited:
- US-A1- 2010 033 190
- US-A1- 2019 391 186
- US-A1- 2020 348 343
- US-B2- 10 126 335

## Description

### Cross Reference to Related Application(s)

This application claims benefit to U.S. Provisional Patent Application No. 63/217,835, filed on July 2, 2021.

### Field of the Invention

The following invention generally relates to systems for the verification of the absence of voltage and more specifically to a system for the verification of the absence of voltage in medium voltage applications.

### Background of the Invention

This application describes novel systems and methods to provide a reliable verification of Absence of Voltage and connectivity of a permanently installed absence of voltage tester (AVT) system that connects to a power line in an electrical equipment in a medium voltage application. The AVT indicates whether the equipment is in an electrically safe state or not without direct access to the equipment.

In order to meet the Safety Integrity Level III (SIL-III) rating, a set of independent and redundant sensing circuitries, as well as connectivity verification technique to the power line must be implemented.

In an electrical installation failure can be an undetached connection due to a faulty termination, thermal expansion, or vibration. Connectivity Verification can be accomplished by verifying that there is continuity throughout the system from the AVT to the main power lines. High isolation of the AVT equipment to the power lines needed to be accomplished. This forces any coupling to the mains to be high impedance in 10's of Mega ohm or 10's of Pico farad for a capacitive coupler.

US 2020/348343 A1 describes, according to its abstract, a system and method for detecting the connectivity of an absence of voltage detector to the source of power to be detected has a first terminal wire connected to a first terminal and a second terminal wire also connected to the first terminal. An RF signal is placed on the first terminal and then its presence is detected on the second signal wire. This method and system can also be placed on each phase of a three phase system.

US 10126335 B2 describes, according to its abstract, a system for the verification of the absence of voltage which includes a first impedance, an amplitude limiter electrically connected to the first impedance, a second impedance electrically connected to the first impedance and the amplitude limiter, a varactor circuit electrically connected to the second impedance, an isolation capacitor electrically connected to the second impedance and varactor circuit, an envelope circuit with a voltage detection circuit connected to the isolation circuit via a buffer, and an RF oscillator. The amplitude limiter configured to limit the voltage applied to the varactor circuit. The RF oscillator configured to interact with the varactor circuit in order to create a modulated circuit for the buffer and envelope circuit. The envelope circuit is configured to demodulate the signal for the voltage detection circuit.

### Summary of the Invention

In an example not encompassed by the wording of the claims but useful for understanding the invention, there is provided , a system for the verification of the absence of voltage has a first series of resistors and a first voltage limiter connected between a power line and a first voltage sensor such as to limit a sensed voltage to a set amount above a threshold set by a standard along with a first series of LC resonance filters connected between the power line and a RF signal generator wherein the RF signal generator and the first voltage sensor share a lead line. The system also has a second series of resistors and a second voltage limiter connected between the power line and a second voltage sensor such as to limit the sensed voltage to a set amount above a threshold set by a standard and a second series of LC resonance filters connected between the power line and an RF signal detector wherein the RF signal detector and the second voltage sensor share a lead line. The system is configured to detect continuity to the voltage line by sending an RF signal generated by the RF signal generator through the first lead line and detecting it at the RF signal detector via the second lead line.

In an embodiment of the invention, a system for the verification of the absence of voltage has a first series of resistors and a first voltage limiter connected between a power line and a first voltage sensor such as to limit the voltage to a set amount above a threshold set by a standard and a second series of resistors and a second voltage limiter connected between the power line and a second voltage sensor such as to limit the voltage to a set amount above a threshold set by a standard. The system also has an RF charge pump connected to the power line via a series of LC resonance filters such as to apply a voltage to the voltage line that can be detected by the first and second voltage detectors.

### Brief Description of the Figures

Figure 1 shows a first example of a system for the verification of the absence of voltage which illustrates a system block diagram to the two independent and redundant voltage detection channels combined with a RF coupler path from tester to the power mains.
Figure 2 illustrates the connectivity detection block diagram.
Figure 3 illustrates an implementation of the concept.
Figure 4 illustrates a mechanical implementation using a HVCI that is potted with epoxy.
Figure 5 illustrates an attachment method of the redundant HVCI to a Medium voltage busbar.
Figure 6 illustrates integration of the two circuit in to one HVCI build.
Figure 7 shows an embodiment according to the invention of an absence of voltage system which illustrates a system block diagram for a novel concept for absence of voltage detection and connectivity verification.
Figure 8 shows the tester generating an RF signal that is connected to RF charge pump throughout series of LC resonance filters.
Figure 9 illustrates an implementation of the concept.
Figure 10 illustrates a potential mechanical implementation of the two resistive couplers, RF coupler, and a charge pump into an HVCI. A Set of Coaxial connection links is used to connect the HVCI to the tester.
Figure 11 illustrates a potential attachment of the HVCI to the Power lines.

### Detailed Description of the Invention

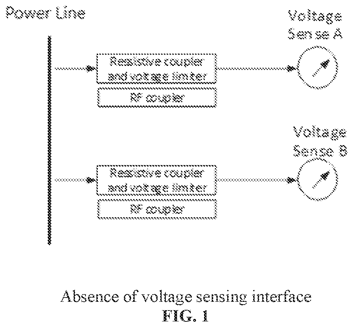

Figure 1 shows a first example of a system for the verification of the absence of voltage which illustrates a system block diagram to the two independent and redundant voltage detection channels combined with a RF coupler path from tester to the power line. Activating the tester will ensure there is no voltage over threshold value on either of the sensing channels, then the tester will perform a connectivity test.

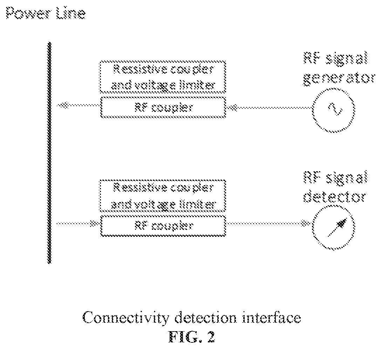

Figure 2 illustrates the connectivity detection block diagram. The connectivity tester generates an RF signal that is connected to the grid though the transmitter RF coupler, which is embedded into a high voltage ceramic insulator (HVCI). The connectivity RF detector is connected to a separate RF coupler in a separate HVCI. This structure ensures that the link from HVCI-1 to HVCI-2 to the power line is valid. This circuitry/procedure is implemented and performed for each one of the three phases to verify the AVT connectivity to the power lines.

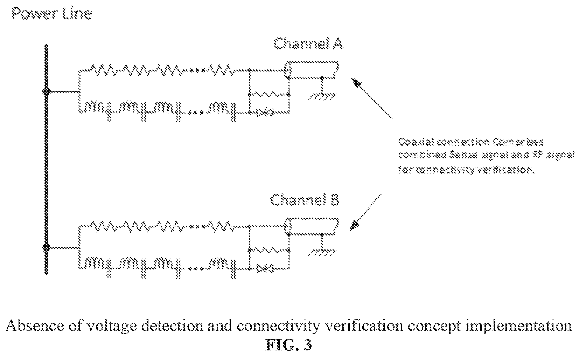

Figure 3 illustrates an implementation of the concept. A series of resistors are used between the power line and AVT for voltage sense. A voltage limiter is used on the secondary side (gigantic impedance side) to limit the voltage to 120% of the absence of voltage threshold defined by the standard.

The RF couplers are mainly isolated throughout a series of LC resonance filters. These filters are constructed from X1Y1 capacitors and high-frequency inductors in series, forming a resonance band-pass filter. Each of the X1Y1 capacitors can be rated at 760VAC/1500VDC and form capacitive coupling and reinforced isolation between primary (i.e., power lines) and secondary (i.e., connectivity detection) circuits.

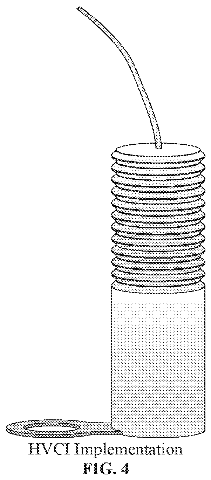

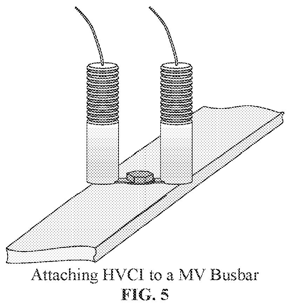

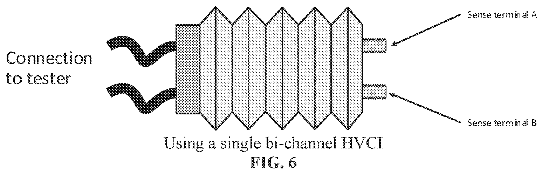

Figure 4 illustrates a mechanical implementation using a HVCI that is potted with epoxy. A Coaxial connection is used to connect the circuitry inside the HVCI to the main AVT system for absence of voltage detection and connectivity verification. Each phase will have two redundant channels. Each channel isolation interface (depicted in Figure 3) will be embedded inside a HVCI. Figure 5 illustrates an attachment method of the redundant HVCI to a medium voltage busbar. Figure 6 illustrates integration of the two circuit in to one HVCI build.

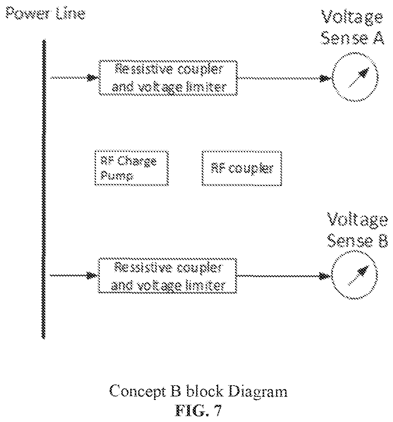

Figure 7 shows an embodiment according to the invention of an absence of voltage system which illustrates a system block diagram for a novel concept for absence of voltage detection and connectivity verification. Like the first example, there are two independent/redundant channels for verifying absence of voltage. These channels are also used for verifying connectivity but with different concept.

The new concept utilizes an RF coupler and RF charge pump. Activating the tester will ensure there is voltage on either of the sensing channels, then the tester will perform a connectivity and "test the tester" assessment.

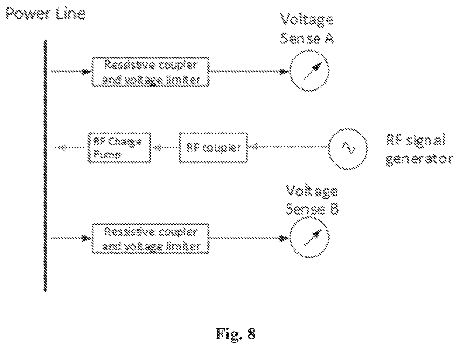

Depicted on Figure 8, the tester generates an RF signal that is connected to RF charge pump throughout series of LC resonance filters. The charge pump connects to the power line. The RF signal will build up a relatively small voltage on the charge pump. The two absence of voltage channels will be used to detect the voltage produced by the charge pump. The outcome of the detection will not only be used for connectivity verification but also verifying the sensing circuits functionality. This procedure must be performed for all three phases.

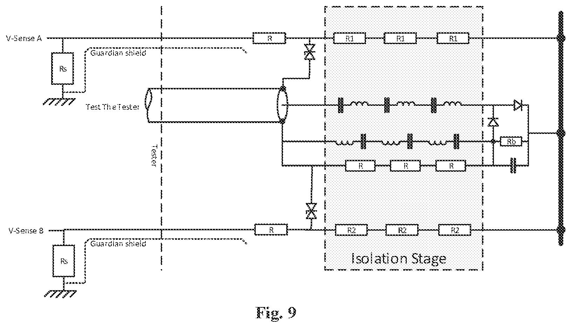

Figure 9 illustrates an implementation of the concept. Series of resistors is used between the power line and AVT for voltage sense. A voltage limiter is used on the secondary side (gigantic impedance side) to limit the voltage to 120% of the Absence of voltage threshold defined by the standard.

The RF couplers are mainly isolated throughout a series of LC resonance filters. These filters are constructed from X1Y1 capacitors and high-frequency inductors in series, forming a resonance band-pass filter. Each of the X1Y1 capacitors are rated at 760VAC/1500VDC and form capacitive coupling and reinforced isolation between primary (i.e., power lines) and secondary (i.e., connectivity detection) circuits. The charge pump functionality can be realized using two RF diodes, a capacitor and a discharge resistor. Series of resistor provides an offset/reference point to the charge pump.

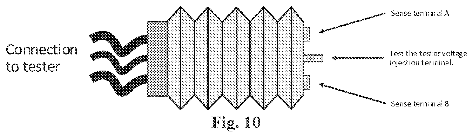

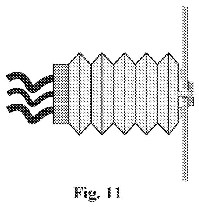

Figure 10 illustrates a potential mechanical implementation of the two resistive couplers, RF coupler, and a charge pump into an HVCI. A set of coaxial connection links is used to connect the HVCI to the tester. Figure 11 illustrates a potential attachment of the HVCI to the power line.

While exemplary embodiments are described above, it is not intended that these embodiments describe all possible forms of the invention. Rather, the words used in the specification are words of description rather than limitation, and it is understood that various changes may be made without departing from the scope of the invention as defined by the claims. Additionally, the features of various implementing embodiments may be combined to form further embodiments of the invention.

## Claims

1. A system for the verification of the absence of voltage comprising
a first series of resistors and a first voltage limiter connected between a power line and a first voltage sensor such as to limit the voltage to a set amount above a threshold set by a standard;
a second series of resistors and a second voltage limiter connected between the power line and a second voltage sensor such as to limit the voltage to a set amount above a threshold set by a standard; and
an RF charge pump connected to the power line via a series of LC resonance filters such as to apply a voltage to the voltage line that can be detected by the first and second voltage detectors.

2. The system of claim 1 wherein the first series of resistors, the second series of resistors, and the series of LC resonance filters are encapsulated in a ceramic housing.

## Patentansprüche

1. System zum Verifizieren der Abwesenheit einer Spannung, umfassend:
eine erste Reihe von Widerständen und einen ersten Spannungsbegrenzer, die zwischen eine Stromleitung und einen ersten Spannungssensor geschaltet sind, um die Spannung auf eine eingestellte Größe über einem Schwellenwert zu begrenzen, der durch eine Norm festgelegt wird;
eine zweite Reihe von Widerständen und einen zweiten Spannungsbegrenzer, die zwischen die Stromleitung und einen zweiten Spannungssensor geschaltet sind, um die Spannung auf eine eingestellte Größe über einem Schwellenwert zu begrenzen, der durch eine Norm festgelegt wird;
eine HF-Ladungspumpe, die über eine Reihe von LC-Resonanzfiltern mit der Stromleitung verbunden ist, um eine Spannung an die Spannungsleitung anzulegen, die durch den ersten und zweiten Spannungsdetektor erkannt werden kann.

2. System nach Anspruch 1, wobei die erste Reihe von Widerständen, die zweite Reihe von Widerständen und die Reihe von LC-Resonanzfiltern in einem Keramikgehäuse eingekapselt sind.

## Revendications

1. Système de vérification de l'absence de tension, comprenant
une première série de résistances et un premier limiteur de tension connectés entre une ligne d'alimentation électrique et un premier capteur de tension de manière à limiter la tension à une quantité fixée au-dessus d'un seuil fixé par une norme ;
une deuxième série de résistances et un deuxième limiteur de tension connectés entre la ligne d'alimentation électrique et un deuxième capteur de tension de manière à limiter la tension à une quantité fixée au-dessus d'un seuil fixé par une norme ; et
une pompe de charge RF connectée à la ligne d'alimentation électrique par l'intermédiaire d'une série de filtres de résonance LC de manière à appliquer à la ligne de tension une tension pouvant être détectée par les premier et deuxième détecteurs de tension.

2. Système selon la revendication 1, dans lequel la première série de résistances, la deuxième série de résistances et la série de filtres de résonance LC sont encapsulées dans un boîtier en céramique.
